## Europäisches Patentamt

## European Patent Office

## Office européen des brevets

(19)

(11) Veröffentlichungsnummer: **0 010 690**
**B1**

(12) **EUROPÄISCHE PATENTSCHRIFT**

(45) Veröffentlichungstag der Patentschrift:
16.03.83

(51) Int. Cl.³: **G 03 F 7/10**, G 03 C 1/68

(21) Anmeldenummer: **79104016.5**

(22) Anmeldetag: **18.10.79**

(54) **Photopolymerisierbare Mischung für die Herstellung von Druck- und Reliefformen sowie damit hergestellte Elemente und Reliefformen.**

(30) Priorität: **26.10.78 DE 2846647**

(43) Veröffentlichungstag der Anmeldung:
**14.05.80 Patentblatt 80/10**

(45) Bekanntmachung des Hinweises auf die Patenterteilung:
**16.03.83 Patentblatt 83/11**

(84) Benannte Vertragsstaaten:
**BE CH DE FR GB IT NL SE**

(56) Entgegenhaltungen:
**DE-A-2 114 767**
**DE-B-1 081 229**
**DE-B-1 121 928**
**DE-B-1 268 765**

(73) Patentinhaber: **BASF Aktiengesellschaft,**
**Carl-Bosch-Strasse 38, D-6700 Ludwigshafen (DE)**

(72) Erfinder: **Vyvial, Rudolf, Dipl.-Ing.,**
**Alwin-Mittasch-Platz 11, D-6700 Ludwigshafen (DE)**
Erfinder: **Wallbillich, Guenter, Dr. Dipl.-Chem.,**
**Eichendorfallee 15, D-6707 Schifferstadt (DE)**
Erfinder: **Trapp, Horst, Dr., Dipl.-Chem.,**
**Johann-Sebastian-Bach-Strasse 10A, D-6831 Plankstadt**
**(DE)**

## Photopolymerisierbare Mischung für die Herstellung von Druck- und Reliefformen sowie damit hergestellte Elemente und Reliefformen

Die Erfindung betrifft verbesserte photopolymerisierbare Mischungen für die Herstellung von mit Wasser entwickelbaren Druck- und Reliefformen auf der Basis einer Photoinitiator enthaltenden, in Wasser löslichen oder dispergierbaren Mischung eines N-Vinylpyrrolidon- oder Vinylalkohol-Polymeren und eines Monomeren sowie daraus hergestellte Formkörper.

Photopolymerisierbare Mischungen auf der Basis von wasserauswaschbaren Polymeren und Monomeren für die Herstellung von Druck- und Reliefformen sind an sich bekannt. So beschreiben z. B. die GB-PS 834337, 1233883 und 1351475 Mischungen von Polyvinylalkoholen mit verschiedenen Monomeren für die Herstellung von Druck- und Reliefformen. Auch die Verwendung von Derivaten des Polyvinylalkohols in photopolymerisierbaren Mischungen ist bekannt, vgl. z. B. die DE-B1-1121928 und die GB-PS 786119, 815277 und 835849. Die bekannten Druckplatten auf der Basis solcher Polymere lassen jedoch bezüglich ihrer Herstellung, Lagerung und Verarbeitbarkeit noch einige Wünsche offen.

So sind in manchen Fällen auch bei Anwendung ausgewählter Bindemittel ihre Extrudierbarkeit, die Wasserlöslichkeit der photopolymerisierbaren Mischungen, die Entfernung des Wassers aus den Platten, die Lagerfähigkeit sowie die Auswaschbarkeit der unbelichteten Bestandteile der photopolymerisierbaren Schicht bei der Reliefentwicklung nicht befriedigend.

Der vorliegenden Erfindung lag die Aufgabe zugrunde, die bekannten Mischungen für die Herstellung wasserentwickelbarer Druck- und Reliefformen auf der Basis von N-Vinylpyrrolidon- und/ oder Vinylalkohol-Polymeren und zugemischten Monomeren so zu modifizieren, dass sie die genannten Nachteile bei der Verarbeitung nicht oder zumindest in geringerem Ausmass zeigen.

Es wurde nun gefunden, dass die gewünschte Verbesserung erzielt werden kann mit einer photopolymerisierbaren Mischung für die Herstellung von mit Wasser entwickelbaren Druck- und Reliefformen auf der Basis (d. h. zu mehr als 50 Gew.-% bestehend aus) einer Photoinitiator enthaltenden, in Wasser löslichen oder dispergierbaren Mischung von (a) mindestens einem in Wasser löslichen oder dispergierbaren Polymeren mit einpolymerisierten N-Vinylpyrrolidon-Einheiten und/ oder einem in Wasser löslichen oder dispergierbaren Polymeren mit Vinylalkohol-Einheiten mit (b) mindestens einem olefinisch ungesättigten photopolymerisierbaren Monomeren, die dadurch charakterisiert ist, dass zumindest ein Teil des Polymeren ein wasserlösliches modifiziertes Vinylalkohol-Polymeres darstellt, das in einer Menge von 5 bis 75 und insbesondere 10 bis 60 Gew.-% im Polymermolekül chemisch gebundene $[O-CH_2-CH_2-]_x$-Einheiten enthält, wobei x mindestens 4 bedeutet.

Die Anwendung der genannten modifizierten Vinylalkohol-Polymeren gemäss der Erfindung in den Polymer-Monomer-Mischungen hat eine Reihe von z. T. unerwarteten Vorteilen. Ist bei den üblichen Polyvinylalkohol-Monomer-Mischungen für Druckplatten die Auswahl eines geeigneten, oft teuren Polyvinylalkohols für die Erzielung befriedigender Produkteigenschaften kritisch, so erlauben die erfindungsgemässen Zusätze die Verwendung auch anderer, billigerer und bisher nicht einsetzbarer Polyvinylalkohole. Sie erleichtern wesentlich die Herstellung von Druckplatten mit reproduzierbaren Eigenschaften auch bei den unvermeidbaren Schwankungen in den Eigenschaften der Polyvinylalkohol-Bindemittel durch deren chargenweise Herstellung. Die erfindungsgemässen Polymerzusätze der Mischung erlauben zudem, andere, die Produkteigenschaften bestimmende Rezepturbestandteile in viel weiteren Grenzen zu variieren, gestatten höhere Gehalte an bestimmten Monomeren und die Mitverwendung mancher Monomerer, die bisher als unverträglich eingestuft und daher nicht mitverwandt wurden.

Die erfindungsgemässen Mischungen zeigen aber auch gegenüber den bekannten Mischungen auf der Basis von Polyvinylalkohol und Monomeren eine verbesserte Verarbeitbarkeit. Die Herstellung klarer homogener Lösungen ist erleichtert, ebenso tritt bei der Formgebung ein Entmischen sowie bei der Trocknung und Lagerung der Druckplatten ein Auswandern von Rezepturbestandteilen wie von Monomeren praktisch nicht mehr auf, was gewerbehygienische Belastungen der Umgebung bei der Verarbeitung der Mischungen z. B. zu Druckplatten als auch bei der Klischeeherstellung vermeidet. Bei der Klischeeherstellung zeigen aus erfindungsgemässen Mischungen hergestellte Druckplatten zudem den Vorteil, dass das Negativ nicht verklebt und sich beim Belichten nicht zusetzt; auch weisen sie eine verkürzte Auswaschzeit auf. Aus erfindungsgemässen Mischungen in üblicher Weise hergestellte Klischees bzw. Reliefformen weisen gegenüber den vergleichbaren des Standes der Technik eine geringere Feuchtigkeitsempfindlichkeit, eine verringerte Sprödigkeit und eine verbesserte Farbannahme auf.

Wasserlösliche modifizierte Vinylalkohol-Polymere, die in einer Menge von 5 bis 75, bevorzugt 10 bis 60 und insbesondere 15 bis 40 Gew.-% $[O-CH_2-CH_2]_x$-Einheiten, d. h. mehrere zusammenhängende umgesetzte Äthylenoxid-Einheiten im Polymermolekül chemisch gebunden enthalten, sind an sich bekannt und ihre Herstellung ist z. B. in den Deutschen Patentschriften 575141, 1081229, 1094457, der Französischen Patentschrift 1239634 und der US-Patentschrift 3052652 beschrieben. Geeignet sind solche modifizierten Vinylalkohol-Polymeren, die zumindest den grösseren Teil der Äthylenoxid-Einheiten in Form von $(O-C-C)_x$-Blöcken gebunden enthalten, wobei x mindestens 4 bedeutet.

Sehr geeignete wasserlösliche modifizierte Vinylalkohol-Polymere sind wasserlösliche Umsetzungsprodukte eines Vinylalkohol-Polymeren bzw. Polyvinylalkohols mit Äthylenoxid, wobei der Anteil der umgesetzten Äthylenoxid-Einheiten im Umsetzungsprodukt den vorgenannten Prozentsatz ausmacht, der sich auf das fertige Umsetzungsprodukt bezieht. Die Herstellung der Umsetzungsprodukte ist an sich bekannt und z. B. in der Deutschen Patentschrift 575141, der Französischen Patentschrift 1 239 634 und der US-Patentschrift 3 052 652 angegeben. Sie können durch Umsetzung der Vinylalkohol-Polymeren mit Äthylenoxid unter den für Oxäthylierung üblichen Bedingungen in Gegenwart von sauren oder basischen Katalysatoren hergestellt werden. Geeignete Katalysatoren für die Umsetzung von Polyvinylalkohol mit Äthylenoxid sind z. B. Antimonpentafluorid, Aluminiumchlorid, Schwefelsäure, Bortrifluorid-Ätherat, Alkalihydroxid, Alkalialkoholat, Amine, Benzyltrimethylammoniumhydroxid, von denen Schwefelsäure, Bortrifluorid-Ätherat und Benzyltrimethylammoniumhydroxid bevorzugt sind. Im allgemeinen erfolgt die Oxalkylierung bei 30 bis 150°C während etwa 2 bis 12 Stunden. Als Vinylalkohol-Polymere bzw. Polyvinylalkohole, worunter Polymere und Copolymere verstanden werden, die wiederkehrende $-CH_2-CH(OH)-$Einheiten im Polymermolekül enthalten, sind für die Umsetzung solche geeignet, die bei der Umsetzung mit Äthylenoxid wasserlösliche Umsetzungsprodukte geben. Besonders geeignet sind zu etwa 70 bis 100 Mol-% verseifte Polyvinylester, insbesondere verseifte Polyvinylacetate mit einem Molekulargewicht von etwa 5000 bis 20 000 und insbesondere 15 000 bis 50 000.

Recht geeignete wasserlösliche modifizierte Vinylalkohol-Polymere sind ferner solche, die durch Verseifung eines Pfropfpolymerisats von Vinylestern von Monocarbonsäuren auf Polyäthylenglykol hergestellt sind. Die Herstellung solcher modifizierter Vinylalkohol-Polymerer ist besonders in den Deutschen Patentschriften 1 081 229 und 1 094 457 beschrieben, die Herstellung der Ausgangsprodukte, der Vinylester-Pfropfpolymerisate insbesondere in der Deutschen Patentschrift 1 077 430. Als Vinylester von Monocarbonsäuren eignen sich für die Herstellung der Pfropfpolymerisate neben z. B. Vinylbenzoat besonders handelsübliche Vinylester von aliphatischen Monocarbonsäuren mit 2 bis 18 C-Atomen, wie Vinylpropionat, Vinylbutyrat und insbesondere Vinylacetat. Als Polyäthylenglykole bzw. Polyäthylenoxide für die Pfropfpolymerisation, die zweckmässigerweise in Gegenwart von radikalischen Aktivatoren in homogener Phase erfolgt, eignen sich solche mit mehr als vier Oxyäthylen-Einheiten im Molekül, bevorzugt solche mit Molekulargewichten von 2000 bis 25 000. Gut geeignet sind modifizierte Polyvinylalkohole dieser Art, bei denen 30 bis 98 Mol-% und insbesondere 60 bis 95 Mol-% der Estergruppen des Vinylester-Pfropfpolymerisats verseift sind. Stets sollen die resultierenden modifizierten Vinylalkohole jedoch wasserlöslich sein.

Die wasserlöslichen modifizierten Vinylalkohol-Polymeren können den anderen Polymerbindemitteln der erfindungsgemässen Mischungen in beliebiger Menge zugegeben werden. Im allgemeinen beträgt die Zusatzmenge 10 bis 100 Gew.-% der Menge der in der Mischung enthaltenden N-Vinylpyrrolidon- und/oder Vinylalkohol-Polymeren, doch kann der modifizierte Polyvinylalkohol auch den überwiegenden Teil (mehr als 50 Gew.-%, z. B. 51 bis 99 Gew.-%) der Gesamtpolymermenge der Mischung oder das alleinige Polymer-Bindemittel in der photopolymerisierbaren Mischung darstellen.

Als Polymere mit einpolymerisierten N-Vinylpyrrolidon-Einheiten kommen die bekannten Homopolymerisate des N-Vinylpyrrolidons als auch die bekannten Copolymerisate des N-Vinylpyrrolidons mit Comonomeren, wie Vinylestern, z. B. Vinylacetat in Frage, soweit sie in Wasser löslich oder zumindest dispergierbar sind. Auch verseifte N-Vinylpyrrolidon-Vinylester-Copolymere sind geeignet.

Als sonstige Polymere mit Vinylalkohol-Einheiten für die photopolymerisierbare Mischung eignen sich die üblichen Polymeren und Copolymeren mit wiederkehrenden $CH_2CH(OH)$-Struktureinheiten in der Polymerkette, soweit diese in Wasser löslich oder dispergierbar sind. Auf den entsprechenden zitierten Stand der Technik sei verwiesen. Besonders geeignet sind die bekannten verseiften Polyvinylester, wie Polyvinylacetate oder Polyvinylpropionate, deren mittlerer Polymerisationsgrad 200 bis 3000 und insbesondere 250 bis 700 und deren Verseifungsgrad 65 bis etwa 100 und insbesondere 80 bis 88 Mol-% beträgt. Auch Gemische von Vinylester-Polymeren oder -Copolymeren mit unterschiedlichem Polymerisationsgrad und/oder Verseifungsgrad können angewandt und für manche Zwecke von Vorteil sein.

Als olefinisch ungesättigte photopolymerisierbare Monomere kommen für die photopolymerisierbare Mischung die bekannten Monomeren mit einer oder mehreren olefinisch ungesättigten Doppelbindungen in Frage, wobei bevorzugt ist, dass zumindest ein Teil der Monomeren mehr als eine olefinisch ungesättigte Doppelbindung enthält. Die Auswahl von Art und Menge der Monomeren wird einerseits von dem beabsichtigten Verwendungszweck der photopolymerisierbaren Mischung, z. B. der gewünschten Härte der Reliefformen daraus bestimmt, andererseits von der Verträglichkeit der Monomeren mit den verwandten Polymeren der Mischung und der Forderung, dass die Mischung in Wasser löslich oder dispergierbar bleiben muss. Die erfindungsgemässe Verwendung des modifizierten Vinylalkohol-Polymeren in den Mischungen erhöht nicht nur die Löslichkeit und Dispergierbarkeit in Wasser, sie trägt auch zur gesteigerten Verträglichkeit mancher Monomeren bei und erweitert somit deren Auswahl nach Art und Menge.

Als Beispiele bevorzugter Monomere seien solche mit Hydroxylgruppen, Amidgruppen und Polyäthylenglykol-Struktureinheiten genannt. Sehr geeignet sind Mono- und Polyacrylate und -methacrylate von ein- und mehrwertigen niedermolekularen Alkoholen, z. B. verträgliche Hydroxyalkyl(meth)—acrylate, wie β-Hydroxyäthylacry-

lat, β-Hydroxypropylacrylat, β-Hydroxyäthylmethacrylat, Äthylenglykol-di(meth)acrylat, Polyäthylenglykol-di(meth)acrylat, Propylenglykol-di-(meth)-acrylat, Butandiol-1,4-di(meth)acrylat, 1,1,1-Trimethylolpropan-tri(meth)acrylat oder Glyzerin-di- und tri-(meth)acrylat. Im allgemeinen beträgt die Gesamtmenge an Monomeren etwa 10 bis 70 Gew.-% der Gesamtmenge an Monomeren und Polymeren im Gemisch und bevorzugt 25 bis 50 Gew.-%.

Die erfindungsgemässen Mischungen enthalten ferner in an sich üblichen Mengen von 0,001 bis 10 Gew.-% der Summe der Mengen an Monomeren und Polymeren mindestens einen Photoinitiator, der mit der Mischung verträglich sein soll. Genannt seien beispielhaft Benzoin und Benzoinverbindungen, wie Benzoinmethyläther, α-Methylbenzoinäthyläther, α-Methylolbenzoinmethyläther, Benzoinisopropyläther, Benzil, Benzilketale, wie Benzildimethylketal oder Benziläthylenglykolketal, mehrkernige Chinone, wie 9,10-Anthrachinon und ähnliche.

Oft ist es auch von Vorteil, den Mischungen andere übliche Hilfsstoffe und Zusätze, wie Inhibitoren, der thermischen Polymerisation, z. B. Hydrochinon, Hydrochinonderivate, Nitrophenole oder Salze des N-Nitrosocyclohexylhydroxylamins, Weichmacher und/oder Farbstoffe zuzugeben, je nach der beabsichtigten Anpassung der Mischung für einen speziellen Anwendungszweck.

Bezüglich der Verarbeitung der Mischung zu Druckplatten und der Herstellung und Entwicklung von Relieformen wird auf den dem Fachmann bekannten Stand der Technik verwiesen wie auf die am Beginn dieser Anmeldung zitierten Patentschriften.

Die in den nachstehenden Beispielen und Vergleichsversuchen genannten Teile und Prozente beziehen sich, soweit nicht anders angegeben, auf das Gewicht. Die angegebenen Molekulargewichte sind Viskositätsmittel der Molekulargewichte.

Die angegebenen K-Werte sind mit 1 gewichtsprozentigen wässrigen Lösungen bestimmt nach H. Fikentscher, Cellulosechemie 13 (1932) 60.

Vergleichsversuch 1

232 Teile eines Polyvinylpyrrolidons des Molekulargewichts 600 000 bis 800 000 (K-Wert 92) werden bei 90°C in 514 Teilen entsalztem Wasser gelöst. Hierauf werden 70,4 Teile 1,1,1-Trimethylolpropantrimethacrylat und anschliessend eine Lösung von 10 Teilen Benzildimethylketal, 0,2 Teilen N-Nitrosocyclolhexylhydroxylamin und 0,02 Teilen Eosin in 91,7 Teilen β-Hydroxyäthylmethacrylat unter Rühren hinzugefügt. Das erhaltene Gemisch war trüb und inhomogen, so dass daraus keine Schicht hergestellt werden konnte.

Beispiel 1

Wie im vorangehenden Vergleichsversuch angegeben, werden 135 Teile eines wasserlöslichen oxäthylierten zu 79 Mol-% verseiften Polyvinylacetats (Molekulargewicht 25 000 bis 30 000; K-Wert 37,5; Gehalt an Oxyäthylen-Einheiten 22%) und 145 Teile des im vorangehenden Vergleichsversuch genannten Polyvinylpyrrolidons nacheinander bei 90°C in 450 Teilen entsalztem Wasser gelöst. Hierauf wird bei 70°C eine Lösung von 12,5 Teilen Benzildimethylketal, 0,25 Teilen N-Nitrosocyclohexylhydroxylamin und 0,025 Teilen Eosin in einer Mischung von 110 Teilen β-Hydroxyäthylmethacrylat und 88 Teilen 1,1,1-Trimethylolpropantrimethacrylat langsam zur wässrigen Lösung hinzugefügt. Die so erhaltene leicht trübe, dickflüssige Lösung wird bei vermindertem Druck entgast, wobei 20 Teile Wasser abdestilliert werden.

Durch Aufbringen auf ein mit einem Haftlack versehenes Stahlblech und 24stündiges Trocknen bei Raumtemperatur wird eine 400 μm starke, harte, nichtklebende Schicht erhalten. Belichten durch ein Negativ mit einem mit Leuchtstoffröhren versehenen Flachbelichter (3 min) und Entwickeln mit Wasser in einem Sprühwascher (2 min; 40°C; 3,2 bar) sowie anschliessendes Trocknen bei erhöhter Temperatur ergibt ein Klischee mit hervorragenden mechanischen Eigenschaften, von dem in einer Probedruckmaschine mehrere Tausend Drucke mit sehr guter Wiedergabe erhalten werden.

Vergleichsversuch 2

232 Teile des in Vergleichsversuch 1 angegebenen Polyvinylpyrrolidons werden in 300 Teilen Methanol gelöst. Hierzu wird eine Lösung von 10,0 Teilen Benzildimethylketal, 0,2 Teile N-Nitrosocyclohexylhydroxylamin und 0,02 Teile Eosin in einem Gemisch von 120 Teilen β-Hydroxyäthylmethacrylat und 38,4 Teilen 1,1,1-Trimethylolpropantrimethacrylat hinzugefügt. Die klare, dickflüssige Lösung wird entgast; dabei werden 62 Teile Methanol abdestilliert. Die hieraus gewonnene, leicht trübe Schicht erhärtet beim Lagern bei Raumtemperatur innerhalb weniger Tage. Gleichzeitig machen sich jedoch in zunehmendem Mass Ausschwitzerscheinungen an der Oberfläche bemerkbar, so dass eine bildmässige Belichtung nicht möglich ist, ohne dass das Negativ beschädigt wird.

Beispiel 2

In Abwandlung des vorstehenden Vergleichsversuchs werden 160 Teile Polyvinylpyrrolidon der oben genannten Art und anschliessend 71,6 Teile des in Beispiel 1 angegebenen oxäthylierten teilverseiften Polyvinylacetats in 370 Teilen entsalztem Wasser gelöst. Hierauf wird eine Lösung von 10,0 Teilen Benzildimethylketal, 0,2 Teilen N-Nitrosocyclohexylamin und 0,02 Teilen Eosin in einem Gemisch von 120 Teilen β-Hydroxyäthylmethacrylat und 38,4 Teilen 1,1,1-Trimethylolpropantrimethacrylat zur wässrigen Lösung hinzugefügt. Nach Entgasung werden unbehandelte Aluminiumbleche etwa 500 μm hoch beschichtet und 24 h bei Raumtemperatur getrocknet. Die so erhaltenen ausreichend harten Platten haben eine trockene Oberfläche, die sich auch bei weiterem Lagern nicht verändert.

Durch ein Negativ wird 1,5 min in einem mit Leuchtstoffröhren bestückten Flachbelichter belichtet, anschliessend mit Wasser in einem Sprühwascher (2 min; 40°C; 3,2 bar) entwickelt und das Klischee anschliessend bei erhöhter Temperatur getrocknet. Die harte, zähe Reliefschicht haftet ausgezeichnet auf dem Trägerblech. Es werden in einer Probedruckmaschine Drucke hoher Qualität erhalten.

Vergleichsversuch 2

249 Teile eines N-Vinylpyrrolidon/Vinylacetat-Copolymerisats (Gewichtsverhältnis 70/30) mit einem K-Wert von 38 werden in 249 Teilen Äthanol gelöst. Hierzu wird die Lösung von 6,0 Teilen $\alpha$-Methylolbenzoinmethyläther, 0,3 Teilen N-Nitrosocyclohexylhydroxylamin und 0,015 Teilen Eosin in 45 Teilen 1,1,1-Trimethylolpropantrimethacrylat unter Rühren hinzugefügt. Der anfangs klare Ansatz trübte sich beim Abdestillieren des Lösungsmittels (1,34 Teile). Er wird auf ein mit einem Haftlack versehenes Trägerblech aufgebracht und zwei Tage bei Raumtemperatur getrocknet. Die Belichtungseigenschaften der so erhaltenen trüben Schicht sind unbefriedigend.

Beispiel 3

Wie im vorangehenden Vergleichsversuch angegeben, werden 174 Teile des oben genannten Vinylpyrrolidon/Vinylacetat-Copolymerisats in 174 Teilen Äthanol gelöst. Ausserdem wird eine Lösung von 75 Teilen eines 22% Oxyäthylen-Einheiten enthaltenden teilverseiften Polyvinylacetats in 150 Teilen entsalztem Wasser hergestellt. Beide Lösungen werden vereinigt und mit einer Lösung von 6,0 Teilen $\alpha$-Methylolbenzoinmethyläther, 0,3 Teilen N-Nitrosocyclohexylhydroxylamin und 0,015 Teilen Eosin in 45 Teilen 1,1,1-Trimethylolpropantrimethacrylat versetzt.

Von der so erhaltenen Ansatzlösung werden 140 Teile abdestilliert. Nach Aufbringen auf ein mit einem Haftlack versehenes Trägerblech und zweitägigem Trocknen bei Raumtemperatur wird eine nicht klebrige, ausreichend feste, nur leicht trübe Schicht von 530 μm Stärke erhalten.

Vorbelichten (2 sek) und anschliessendes bildmässiges Belichten (4 min) mit einem mit Leuchtstoffröhren versehenen Flachbelichter, Entwickeln mit Wasser in einem Sprühwascher (2,5 min; 40°C, 3,2 bar) und Trocknen bei 60°C ergeben ein Klischee mit hervorragenden mechanischen Eigenschaften, von dem in einer Probedruckmaschine ausgezeichnete Andrucke hergestellt werden.

Beispiel 4

294 Teile eines teilverseiften Polyvinylacetats (Verseifungsgrad 82 Mol-%; mittlerer Polymerisationsgrad 500) werden durch mehrstündiges Rühren in 294 Teilen Wasser bei 90°C gelöst. Nach Abkühlen auf 70°C werden 33,5 Teile eines Umsetzungsproduktes von Äthylenoxid mit einem zu 85 Mol-% verseiften Polyvinylacetat (Molekulargewicht 30000 bis 35000; Gehalt an Oxyäthylen-Einheiten 24%) unter Rühren hinzugegeben. Hierauf wird eine Lösung von 51 Teilen Butandiol-1,4-dimethacrylat, 9,6 Teilen Benzildimethylketal und 1,0 Teilen 2,6-Di-tert.butyl-p-kresol in 241 Teilen β-Hydroxyäthylmethacrylat eingerührt. Die homogene, viskose Lösung wird filtriert und bei vermindertem Druck entgast.

Durch Aufbringen auf ein mit einem Haftlack versehenes Stahlblech und 24stündiges Trocknen bei Raumtemperatur wird eine 500 μm starke, nicht klebende Schicht erhalten. Vorbelichten (6 sek) und Belichten durch ein Negativ (60 sek) mit einem mit Leuchtstoffröhren versehenen Flachbelichter und Entwickeln mit Wasser in einem Sprühwascher (2 min 20 sek; 40°C; 3,2 bar) sowie anschliessendes Trocknen bei erhöhter Temperatur ergibt ein Klischee mit hervorragenden mechanischen Eigenschaften, von dem in einer Probedruckmaschine mehrere Tausend Drucke mit sehr guter Wiedergabe erhalten werden.

Beispiel 5

243 Teile eines teilverseiften Polyvinylacetats (Verseifungsgrad 82 Mol-%, mittlerer Polymerisationsgrad 500) werden durch mehrstündiges Rühren in 243 Teilen vollentsalztem Wasser bei 90°C gelöst. Nach Abkühlen auf 70°C werden 81 Teile eines zu 83 Mol-% verseiften Polyvinylacetat (Molekulargewicht 35000 bis 50000; Gehalt an Oxyäthylen-Einheiten 54%) unter Rühren hinzugefügt. Anschliessend wird unter Rühren eine Lösung von 51 Teilen Butandiol-1,4-dimethacrylat, 9,6 Teilen Benzildimethylketal und 1,0 Teil 2,6-Di-tert.butyl-p-kresol in 241 Teilen β-Hydroxyäthylmethacrylat hinzugefügt. Die Ansatzlösung wird filtriert und bei vermindertem Druck entgast.

Durch Aufbringen auf ein mit einem Haftlack versehenes Stahlblech und 24stündiges Trocknen bei Raumtemperatur wird eine 500 μm starke, nicht klebende, homogene Schicht erhalten. Ein Muster wird in einem mit Leuchtstoffröhren versehenen Flachbelichter 5 sek vorbelichtet und anschliessend durch ein Negativ bildmässig belichtet. Die Platte wird in einem Sprühwascher (2 min 15 sek; 40°C; 3,2 bar) entwickelt und bei erhöhter Temperatur getrocknet. Es wird ein Klischee mit guten mechanischen Eigenschaften erhalten; das Relief ist sehr gut ausgebildet und etwas elastisch. Die damit hergestellten Probedrucke sind tadellos.

Beispiel 6

Die Einsatzstoffe sind die selben wie im vorhergehenden Beispiel, es wird lediglich das Mengenverhältnis der polymeren Komponenten variiert; 294 Teile des teilverseiften Polyvinylacetats werden in 294 Teilen vollentsalztem Wasser gelöst und mit 41 Teilen des wasserlöslichen modifizierten Vinylalkohol-Polymeren versetzt. Die übrigen Komponenten bleiben unverändert.

Nach dem gleichen Verfahren wird eine Druckform erhalten, die – bei ähnlichen anwendungstechnischen Eigenschaften – härter als die im vorangehenden Beispiel ist. Die Probedrucke sind auch hier sehr gut.

Beispiel 7

176 Teile eines wasserlöslichen, 22% Oxyäthylen-Einheiten enthaltenden teilverseiften Vinylacetatpolymerisats (Molekulargewicht 25000–

30 000) werden durch mehrstündiges Rühren in 176 Teilen vollentsalztem Wasser bei 80°C gelöst. Nach Abkühlen auf 70°C wird ein Gemisch aus 124 Teilen β-Hydroxyäthylmethacrylat und 26 Teilen Heptaäthylenglykoldimethacrylat, 5 Teilen Benzyldimethylketal und 0,7 Teilen N-Nitrosocyclohexylhydroxylamin eingerührt. Nach Entgasung und vermindertem Druck wird die Lösung auf mit einem Haftlack versehenem Stahlblech aufgebracht. Anschliessend wird 24 h bei Raumtemperatur getrocknet. Die so erhaltene Platte wird in einem Flachbelichter 3 sek vorbelichtet und anschliessend 90 sek durch ein Negativ belichtet. Nach dem Auswaschen (2,5 min, 3,2 bar, 50°C) und Trocknen (120°C, 4 min) erhält man ein Klischee mit hervorragenden Druckeigenschaften.

Beispiel 8

130 Teile eines teilverseiften Polyvinylacetates (Verseifungsgrad 88 Mol%, mittlerer Polymerisationsgrad 500) werden zusammen mit 70 Teilen eines teilverseiften Pfropfpolymerisates (des mittleren Polymerisationsgrades, $P_w$ von ca. 460) von Vinylacetat mit Polyäthylenglykol in 200 Teilen Wasser bei 90°C gelöst. Nach Abkühlung auf 80°C wird hierzu eine Lösung zugegeben, die sich wie folgt zusammensetzt:

160 Teilen von Hydroxypropylacrylat
40 Teilen von Butandiol-1,4-dimethacrylat
6,4 Teilen von Benzildimethylketal
1 Teil Hydrochinon/Hydrochinonmonomethyläther (1:1)

Die so erhaltene homogene Lösung wird filtriert und bei vermindertem Druck entgast.

Durch Aufbringen auf ein mit einem Haftlack versehenes Stahlblech und 24stündiges Trocknen bei Raumtemperatur wird eine 500 μm starke, nicht klebende Schicht erhalten. Nach Vorbelichten (6 sek) und Belichten durch ein Negativ (60 sek) mit einem mit Leuchtstoffröhren versehenen Flachbelichter und Entwickeln mit Wasser in einem Sprühwascher (3,5 min, 40°C, 3 bar) sowie anschliessendes Trocknen bei erhöhter Temperatur entsteht eine einwandfreie Druckreliefform.

**Patentansprüche**

1. Photopolymerisierbare Mischung für die Herstellung von mit Wasser entwickelbaren Druck- und Reliefformen auf der Basis einer Photoinitiator enthaltenden, in Wasser löslichen und dispergierbaren Mischung mindestens eines in Wasser löslichen oder dispergierbaren Polymeren mit einpolymerisierten N-Vinylpyrrolidon-Einheiten und/oder einem Polymeren mit Vinylalkohol-Einheiten und mindestens eines olefinisch ungesättigten photopolymerisierbaren Monomeren, dadurch gekennzeichnet, dass zumindest ein Teil des Polymeren ein wasserlösliches modifiziertes Vinylalkohol-Polymeres darstellt, das in einer Menge von 5 bis 75 Gew.-% im Polymermolekül chemisch gebundene [-O-CH$_2$-CH$_2$-]$_x$-Einheiten enthält, wobei x mindestens 4 bedeutet.

2. Photopolymerisierbare Mischung gemäss Anspruch 1, dadurch gekennzeichnet, dass der Anteil der [-O-CH$_2$-CH$_2$-]$_x$-Einheiten, wobei x mindestens 4 bedeutet, im wasserlöslichen modifizierten Vinylalkohol-Polymeren 10 bis 60 Gew.-% beträgt.

3. Photopolymerisierbare Mischung gemäss Anspruch 1 oder 2, dadurch gekennzeichnet, dass der Gehalt an dem wasserlöslichen modifizierten Polyvinylalkohol mindestens 10 Gew.-% der Menge der in der Mischung enthaltenden N-Vinylpyrrolidon- und/oder Vinylalkohol-Polymeren beträgt.

4. Photopolymerisierbare Mischung gemäss Anspruch 1 oder 2, dadurch gekennzeichnet, dass der wasserlösliche modifizierte Polyvinylalkohol den überwiegenden Teil der Polymermenge in der Mischung oder das alleinige Polymere in der Mischung darstellt.

5. Photopolymerisierbare Mischung gemäss einem der Ansprüche 1 bis 4, dadurch gekennzeichnet, dass das wasserlösliche modifizierte Vinylalkohol-Polymere ein Umsetzungsprodukt eines Vinylalkohol-Polymeren mit Äthylenoxid darstellt, wobei der Anteil der umgesetzten Äthylenoxid-Einheiten im Umsetzungsprodukt 5 bis 75 Gew.-% beträgt.

6. Photopolymerisierbare Mischung gemäss einem der Ansprüche 1 bis 4, dadurch gekennzeichnet, dass das wasserlösliche modifizierte Vinylalkohol-Polymere durch Verseifung eines Pfropfpolymerisats von Vinylestern von Monocarbonsäuren auf Polyäthylenglykol hergestellt ist.

7. Photopolymerisierbare Mischung gemäss Anspruch 6, dadurch gekennzeichnet, dass 30 bis 98 Mol-% der Estergruppen des Vinylester-Pfropfpolymerisats verseift sind.

8. Elemente, insbesondere Platten, für die Herstellung von Druck- und Reliefformen mit einer photopolymerisierbaren Schicht, dadurch gekennzeichnet, dass die photopolymerisierbare Schicht eine photopolymerisierbare Mischung gemäss einem der Ansprüche 1 bis 7 enthält.

9. Reliefformen, deren photopolymerisierte reliefbildende Schicht durch Photopolymerisation einer photopolymerisierbaren Mischung gemäss einem der Ansprüche 1 bis 7 hergestellt ist.

**Claims**

1. A photopolymerizable composition for the production of water-developable printing plates and relief plates, based on a water-soluble or water-dispersible mixture, containing a photoinitiator, of at lease one water-soluble or water-dispersible polymer containing copolymerized N-vinylpyrrolidone units and/or at least one polymer containing vinyl alcohol units with at least one olefinically unsaturated photopolymerizable monomer, wherein at least a proportion of the polymer is a water-soluble modified vinyl alcohol polymer which contains from 5 to 75% by weight of chemically bonded [-O-CH$_2$-CH$_2$]$_x$ units, where x is at least 4, in the polymer molecule.

2. A photopolymerizable composition as claimed in claim 1, wherein the proportion of [-O-CH$_2$-CH$_2$]$_x$ units, where x is at least 4, in the water-soluble modified vinyl alcohol polymer is from 10 to 60% by weight.

3. A photopolymerizable composition as claimed in claim 1 or 2, wherein the amount of the water-soluble modified polyvinyl alcohol is not less than 10% by weight of the amount of N-vinylpyrrolidone polymer and/or vinyl alcohol polymer contained in the mixture.

4. A photopolymerizable composition as claimed in claim 1 or 2, wherein the water-soluble modified polyvinyl alcohol constitutes the greater part of the amount of polymer in the mixture or is the sole polymer in the mixture.

5. A photopolymerizable composition as claimed in any of claims 1 to 4, wherein the water-soluble modified vinyl alcohol polymer is a reaction product of a vinyl alcohol polymer with ethylene oxide, the proportion of reacted ethylene oxide units in the reaction product being from 5 to 75% by weight.

6. A photopolymerizable composition as claimed in any of claims 1 to 4, wherein the water-soluble modified vinyl alcohol polymer has been prepared by hydrolyzing a graft polymer of vinyl esters of monocarboxylic acids onto polyethylene glycol.

7. A photopolymerizable composition as claimed in claim 6, wherein from 30 to 98 mole % of the ester groups of the vinyl ester graft polymer are hydrolyzed.

8. An element, especially a plate, for the production of printing plates and relief plates comprising a photopolymerizable coating, wherein the photopolymerizable coating contains a photopolymerizable composition as claimed in any of claims 1 to 7.

9. A relief plate whose photopolymerized relief-forming coating has been produced by photopolymerizing a photopolymerizable composition as claimed in any of claims 1 to 7.

**Revendications**

1. Mélange photopolymérisable pour la fabrication de formes en relief et d'impression, pouvant être dévelopées avec de l'eau à base d'un mélange hydrosoluble ou dispersable dans l'eau d'au moins un polymère contenant des unités N-vinyl-pyrrolidone copolymérisées et (ou) un polymère à unités alcool vinylique hydrosoluble ou dispersable dans l'eau et d'au moins un monomère à insaturation oléfinique photopolymérisable, ce mélange contenant en outre un photo-initiateur, caractérisé en ce qu'une partie au moins de la fraction polymère est constituée d'un polymère d'alcool vinylique modifié hydrosoluble, la molécule du polymère contenant entre 5 et 75% en poids d'unités $[-O-CH_2-CH_2]_x$, x valant au moins 4, liées chimiquement.

2. Mélange photopolymérisable suivant la revendication 1, caractérisé en ce que la proportion des unités $[-O-CH_2-CH_2]_x$ avec x = 4 ou plus dans le polymère d'alcool vinylique modifié hydrosoluble se situe entre 10 et 60% en poids.

3. Mélange photopolymérisable suivant la revendication 1 ou la revendication 2, caractérisé en ce que l'alcool polyvinylique modifié hydrosoluble constitue au moins 10% du poids des polymères à unités N-vinyl-pyrrolidone et (ou) alcool vinylique présents dans le mélange.

4. Mélange photopolymérisable suivant la revendication 1 ou la revendication 2, caractérisé en ce que l'alcool polyvinylique modifié hydrosoluble constitue la fraction majeure des polymères du mélange ou en est le composant polymère unique.

5. Mélange photopolymérisable suivant l'une des revendications 1 à 4, caractérisé en ce que le polymère d'alcool vinylique modifié hydrosoluble est le produit de la réaction d'un alcool polyvinylique et d'oxyde d'éthylène avec une proportion en unités oxyde d'éthylène liées comprise entre 5 et 75% en poids.

6. Mélange photopolymérisable suivant l'une des revendications 1 à 4, caractérisé en ce que le polymère d'alcool vinylique modifié hydrosoluble est préparé par saponification d'un polymère de greffage d'esters vinyliques d'acides mono-carboxyliques sur du polyéthylène-glycol.

7. Mélange photopolymérisable suivant la revendication 6, caractérisé en ce que les groupes ester du polymère de greffage d'ester vinylique sont saponifiés à raison de 30 à 98% molaires.

8. Eléments, en particulier plaques, pour la fabrication de formes en relief et d'impression, comprenant une couche photopolymérisable, caractérisés en ce que cette couche photopolymérisable contient un mélange photopolymérisable selon l'une des revendications 1 à 7.

9. Formes à relief, dont la couche photopolymérisée produisant le relief est réalisée par photopolymérisation d'un mélange photopolymérisable suivant l'une des revendications 1 à 7.